# EUROPÄISCHE PATENTSCHRIFT

(11) **EP 2 333 567 B1**
(45) Veröffentlichungstag und Bekanntmachung des Hinweises auf die Patenterteilung: **19.03.2014**
(21) Anmeldenummer: 10192650.9
(22) Anmeldetag: 26.11.2010
(51) Int. Cl.: G01R 15/20

(54) **Vorrichtung zur Strommessung**
Device for measuring current
Dispositif de mesure de courant

(30) Priorität: 30.11.2009 CH 18382009; 31.03.2010 CH 4732010
(43) Veröffentlichungstag der Anmeldung: 15.06.2011
(73) Patentinhaber: Melexis Technologies NV, 3980 Tessenderlo (BE)
(72) Erfinder: Racz, Robert, 6300 Zug (CH)
(74) Vertreter: Falk, Urs

(56) Entgegenhaltungen:
- EP-A1- 1 746 426
- EP-A1- 1 811 311
- JP-A- H06 130 088

## Beschreibung

Die Erfindung betrifft eine Vorrichtung zur Strommessung.

Um den Ladezustand einer Batterie anzeigen zu können, ist es nötig, auch den während des Stand-by Betriebs oder im ausgeschalteten Zustand fliessenden Strom zu messen und über die Zeit zu integrieren. Diese Stand-by Ströme sind sehr klein, sie liegen typischerweise im Bereich von 10 bis 100 Milliampere. Wenn die Batterie belastet wird, dann fliessen Ströme von bis zu 100A, kurzzeitig von bis zu 1000A.

Aus dem Stand der Technik sind eine Vielzahl von Stromsensoren bzw. Vorrichtungen zur Strommessung bekannt. EP 1811311 offenbart eine Vorrichtung zur Strommessung, die sich für die Messung von Strömen bis zu typischerweise 100A eignet, kurzzeitig mit einem Überlaststrom von bis zu 1000A belastbar ist und gegen äussere magnetische Störfelder abgeschirmt ist. CH 696859 und JP 62098267 offenbaren Stromsensoren, bei denen ein erster Hallsensor im Luftspalt eines Jochs aus ferromagnetischem Material angeordnet ist, das den Stromleiter umschliesst, und ein zweiter Hallsensor ausserhalb des Jochs angeordnet ist. Das Joch und der erste Hallsensor dienen zur Messung relativ kleiner Ströme, der zweite Hallsensor dient zur Messung relativ grosser Ströme. Nachteilig bei diesen letzteren Stromsensoren ist, dass der Luftspalt mit typischerweise 1-3 mm relativ gross ist, das Joch viel Material benötigt und die Herstellung aufwendig ist.

Der Erfindung liegt die Aufgabe zugrunde, eine Vorrichtung zur Strommessung zu entwickeln, die im Dauerbetrieb mit einem Strom von bis zu 100 A, kurzzeitig von bis zu 1000A, belastbar ist, bei der die genannten Nachteile behoben sind und die auf einfache und materialsparende Weise herstellbar ist.

Die genannte Aufgabe wird erfindungsgemäss gelöst durch die Merkmale des Anspruchs 1. Vorteilhafte Ausgestaltungen ergeben sich aus den abhängigen Ansprüchen.

Die Erfindung wird nachfolgend anhand von Ausführungsbeispielen und anhand der Zeichnung näher erläutert. Die Figuren sind nicht massstäblich gezeichnet.
- Fig. 1 und 2: zeigen in Aufsicht das Grundprinzip einer erfindungsgemässen Vorrichtung zur Strommessung,
- Fig. 3 - 5: zeigen die Vorrichtung in einem Schnitt entlang der Linie S-S der Fig. 1 für verschiedene Typen von Magnetfeldsensoren,
- Fig. 6: zeigt eine Kennlinie, und
- Fig. 7: zeigt ein weiteres Beispiel einer erfindungsgemässen Vorrichtung.

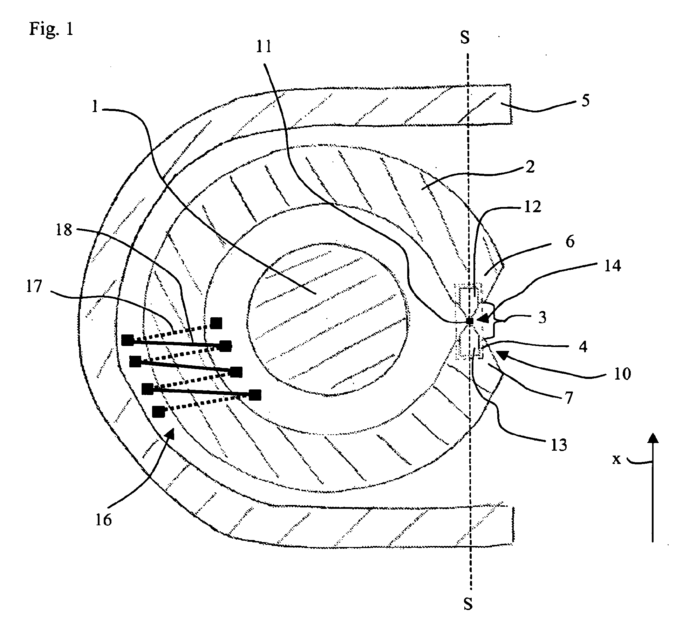

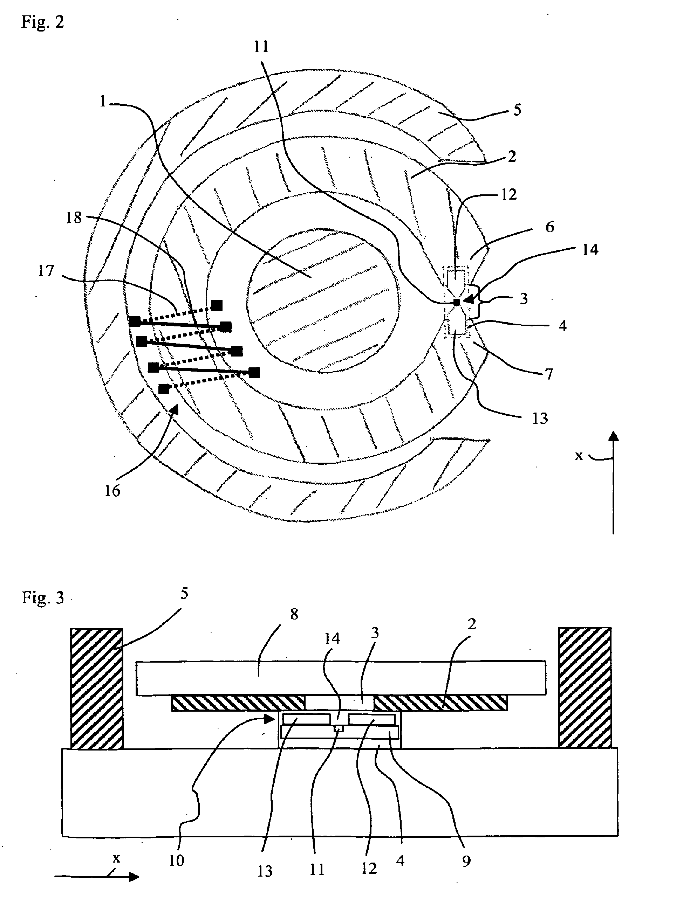

Die Fig. 1 und 2 illustrieren in Aufsicht das Grundprinzip einer erfindungsgemässen Vorrichtung zur Strommessung anhand von zwei weitgehend ähnlichen Ausführungsbeispielen. Die Fig. 3 zeigt das Grundprinzip der Vorrichtung im Schnitt entlang der Linie S-S der Fig. 1. Die Vorrichtung umfasst einen Stromleiter 1, einen Ringkonzentrator 2 mit einem Luftspalt 3, einen Magnetfeldsensor 4, eine Abschirmung 5, sowie eine nicht dargestellte elektronische Schaltung für den Betrieb des Magnetfeldsensors 4. Der Stromleiter 1 erstreckt sich senkrecht zur Ebene, die vom Ringkonzentrator 2 aufgespannt wird, d.h. hier senkrecht zur Zeichenebene. Der Stromleiter 1 ist beispielsweise ein Kabel, ein Stift, eine Batterieklemme, eine Stromschiene oder dergleichen. Der Stromleiter 1 ist aber keine Spule, die um den Ringkonzentrator 2 gewickelt ist. Der zu messende Strom I fliesst durch den Stromleiter 1. Der Magnetfeldsensor 4 ist unterhalb oder oberhalb des Luftspalts 3 Ringkonzentrators 2 angeordnet und dient dazu, das Magnetfeld zu messen, das von dem durch den Stromleiter 1 fliessenden Strom I im Bereich des Luftspalts 3 erzeugt wird. Der Ringkonzentrator 2 und der Magnetfeldsensor 4 umschliessen den Stromleiter 1 vollständig und bilden zusammen einen Magnetkreis.

Der Ringkonzentrator 2 ist ein magnetischer Konzentrator, der aus einem ringförmigen, flachen Streifen aus ferromagnetischem Material gebildet ist, dessen Enden 6 und 7 einander gegenüberliegen und durch den Luftspalt 3 getrennt sind. Der Ringkonzentrator 2 erstreckt sich in einer im wesentlichen senkrecht zum Stromleiter 1 verlaufenden Ebene, besteht typischerweise aus einer Ni-Fe Legierung oder einem amorphem Metall und ist relativ dünn: Die senkrecht zur Ebene gemessene Dicke des Ringkonzentrators 2 beträgt höchstens einige Zehntel Millimeter, während seine Breite in der Ebene etwa 3 bis 5 mm beträgt. Die Dicke des Ringkonzentrators 2 ist somit um mindestens einen Faktor 10, typischerweise um einen Faktor 30 bis 250 geringer als eine in der Ebene gemessene Breite. Bevorzugt hat der Ringkonzentrator 2 eine Dicke von wenigstens 20 µm, typischerweise etwa 100 µm, und eine Breite von 3 bis 5 mm, so dass er bei einem Strom I von etwa 5 bis 10 A bereits magnetisch in Sättigung geht. Die Form des Ringkonzentrators 2 ist bevorzugt dem Stromleiter 1 angepasst, sie kann kreisrund, rechteckförmig oder beliebig anders sein.

Der Ringkonzentrator 2 besteht aus einem dünnen Blech oder aus einem Laminat aus übereinander angebrachten dünnen Blechen und wird auf einen Träger 8 (Fig. 3 - 5) aufgebracht. Der Ringkonzentrator 2 kann auch in Dickfilmtechnologie gebildet werden, beispielsweise durch Electro-Plating auf den Träger 8. Der Träger 8 ist beispielsweise eine Keramikplatte oder eine Leiterplatte. Der Träger 8 gibt dem Ringkonzentrator 2 die notwendige mechanische Stabilität.

Der Magnetfeldsensor 4 misst vorzugsweise diejenige Komponente des Magnetfeldes, die parallel zu der Ebene verläuft, die vom Ringkonzentrator 2 aufgespannt wird. Diese Komponente ist in den Figuren als x-Komponente bezeichnet.

Der Magnetfeldsensor 4 umfasst einen Halbleiterchip 9 (Fig. 3 - 5), der die für den Betrieb des Magnetfeldsensors 4 nötige Betriebs- und Auswerteelektronik enthält. Auf dem Halbleiterchip 9 ist ein magnetisches Element 10 aufgebracht, dessen Abmessungen so bemessen sind, dass es den Luftspalt 3 des Ringkonzentrators 2 im wesentlichen überbrückt: Ein erster Endbereich des magnetischen Elementes 10 und ein erster Endbereich (beim ersten Ende 6) des Ringkonzentrators 2 sowie ein zweiter Endbereich des magnetischen Elementes 10 und ein zweiter Endbereich (beim zweiten Ende 7) des Ringkonzentrators 2 überlappen. Das magnetische Element 10 ist also länger als der Luftspalt 3 des Ringkonzentrators 2 breit ist.

Der Halbleiterchip 9 ist in einem Gehäuse, mit Vorteil in einem Standard-Kunststoffgehäuse wie z.B. einem S0-8 Gehäuse oder in einem oben offenen Kunststoffgehäuse wie z.B. einem so genannten ,,open cavity" SO-8 Gehäuse, untergebracht. Dies ermöglicht es, den Magnetfeldsensor 4 zu testen und als getestetes Bauteil in einem Standard Montageprozess zu montieren.

Bei einem offenen Gehäuse kann der Ringkonzentrator 2 das magnetische Element 10 direkt berühren, unter Umständen sind seine Endbereiche noch dementsprechend zu biegen. Der Ringkonzentrator 2 und das magnetische Element 10 können aber auch durch eine Gehäusewand des Magnetfeldsensors 4 voneinander getrennt sein.

Das magnetische Element 10 minimiert auf diese Weise den effektiv wirksamen Luftspalt des Magnetkreises, der durch den Ringkonzentrator 2 und das magnetische Element 10 gebildet ist, und ermöglicht zudem eine problemlose Montage des Magnetfeldsensors 4. Im Endergebnis ist der wirksame Luftspalt des Magnetkreises entweder sehr klein und präzise definiert oder in seiner Wirkung im Magnetkreis vernachlässigbar und das Ausgangssignal des Magnetfeldsensors 4 ist annähernd unabhängig von unvermeidlichen Toleranzen des Luftspalts 3 des Ringkonzentrators und Montagetoleranzen des Magnetfeldsensors 4.

Die Ausgestaltung und Struktur des magnetischen Elements 10 hängt davon ab, auf welchem physikalischen Effekt oder Prinzip die Messung des Magnetfeldes beruht. Anhand der folgenden Figuren werden Magnetfeldsensoren beschrieben, die auf dem Halleffekt, dem magnetoresistiven Effekt oder dem Fluxgate Prinzip beruhen.

Der in den Fig. 1 bis 3 dargestellte Magnetfeldsensor 4 basiert auf dem Halleffekt und umfasst ein vertikales Hallelement 11. Das magnetische Element 10 besteht aus zwei Magnetfeldkonzentratoren 12, 13, die durch einen Luftspalt 14 getrennt sind. Das vertikale Hallelement 11 ist in herkömmlicher Weise in den Halbleiterchip 9 integriert und befindet sich etwa in der Mitte des Luftspalts 14. Die für den Betrieb des vertikalen Hallelements 11 nötige Betriebs- und Auswerteelektronik ist ebenfalls in den Halbleiterchip 9 integriert. Die Herstellung der Magnetfeldkonzentratoren 12, 13 erfolgt, indem eine Schicht aus ferromagnetischem Material auf einen noch nicht zersägten Wafer mit den Halbleiterchips 9 aufgebracht und diese Schicht anschliessend durch einen Ätzprozess strukturiert wird. Weil die Ätzmaske an Markierungen des Wafers mit den Halbleiterchips 9 ausgerichtet wird, sind die Magnetfeldkonzentratoren 12, 13 mit sehr grosser Genauigkeit bezüglich des vertikalen Hallelements 11 ausgerichtet. Die Breite des Luftspalts 14 zwischen den Magnetfeldkonzentratoren 12, 13 beträgt einige 10 µm, typischerweise etwa 30 µm. Die Magnetfeldkonzentratoren 12, 13 haben eine maximale Länge im Bereich von etwa 0.3 mm bis 0.8 mm und sind gegen den Luftspalt 14 hin bevorzugt verjüngt. Die Enden 6, 7 des Ringkonzentrators 2 sind mit Vorteil ebenfalls - wie dargestellt - verjüngt. Optimal ist, wenn die Enden 6, 7 des Ringkonzentrators 2 ein wenig breiter als die Magnetfeldkonzentratoren 12, 13 sind, nämlich so breit, dass die Magnetfeldkonzentratoren 12, 13 unabhängig von unvermeidlichen, im Toleranzbereich liegenden Montagefehlern auf jeden Fall vollständig mit den Enden 6, 7 des Ringkonzentrators 2 überlappen und nicht seitlich über den Ringkonzentrator 2 hinausragen.

Das vertikale Hallelement 11 wird von Streulinien des Magnetfelds durchflutet, die vom einen Ende 6 des Ringkonzentrators 2 ausgehen und auf das andere Ende 7 des Ringkonzentrators 2 auftreffen. Im Bereich des vertikalen Hallelements 11 verlaufen diese Streulinien annähernd parallel zur Oberfläche des Halbleiterchips 9.

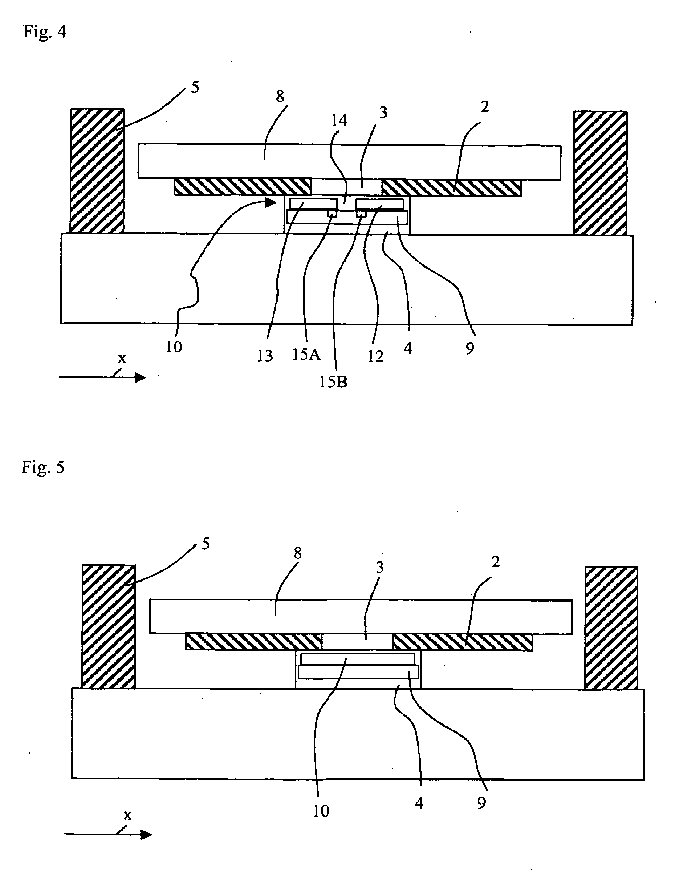

Wenn anstelle eines vertikalen Hallelementes ein horizontales Hallelement verwendet werden soll, dann muss es im Bereich des Randes der Magnetfeldkonzentratoren 12, 13 auf der dem Luftspalt 14 abgewandten Seite angeordnet werden, wo die Streulinien des Magnetfelds annähernd senkrecht zur Oberfläche des Halbleiterchips 9 verlaufen. Die Fig. 4 illustriert ein Ausführungsbeispiel eines Magnetfeldsensors 4 mit zwei horizontalen Hallelementen 15A und 15B, das den Vorteil hat, dass die senkrecht zur Oberfläche des Halbleiterchips 9 verlaufende Komponente der Feldlinien des Streufelds an diesen Orten eine zueinander entgegengesetzte Richtung hat, so dass ein in dieser Richtung verlaufendes Störfeld nicht gemessen wird. Horizontale Hallelemente haben noch immer den Vorteil, dass sie technologisch ausgereifter sind als vertikale Hallelemente.

Bei diesen Ausführungsbeispielen mit Hallelementen erfüllen die Magnetfeldkonzentratoren 12, 13 mehrere Funktionen.
1. Sie verringern die effektive Breite des Luftspalts des durch den Ringkonzentrator 2 und das magnetische Element 10 des Magnetfeldsensors 4 gebildeten Magnetkreises auf einen Wert von einigen 10 µm, typischerweise etwa 30 µm.
2. Sie verstärken das Magnetfeld am Ort der Hallsensoren.

Weil die Magnetfeldkonzentratoren 12, 13 auf dem Halbleiterchip 9 aufgebracht sind, der das vertikale Hallelement 11 oder mindestens ein horizontales Hallelement enthält, ist der Ringkonzentrator 2 mit Vorteil so montiert, dass er nur das Gehäuse des Magnetfeldsensors 4, nicht aber die Magnetfeldkonzentratoren 12, 13 selbst berührt, um stressbedingte Messfehler zu vermeiden. Je nach Bauform kann der Magnetfeldsensor 4 auf der Leiterplatte mit dem Ringkonzentrator 2 montiert werden, oder es kann der Magnetfeldsensor 4 und der Träger 8 mit dem Ringkonzentrator 2 auf einer als Basis dienenden Leiterplatte montiert werden. Bevorzugt ist der Ringkonzentrator 2 auf dem Träger 8 aufgebracht, der Magnetfeldsensor 4 in einem Gehäuse verpackt und die Enden 6, 7 des Ringkonzentrators 2 liegen auf dem Gehäuse des Magnetfeldsensors 4 auf. Weil die Endbereiche der Magnetfeldkonzentratoren 12, 13 relativ grossflächig mit Endbereichen des Ringkonzentrators 2 überlappen, hat ein allfälliger Luftspalt bzw. eine allfällige Gehäusewand einen verschwindend kleinen Einfluss auf den effektiv wirksamen Luftspalt des Magnetkreises.

Die Fig. 5 zeigt einen Magnetfeldsensor 4, der auf der Ausnutzung eines magnetoresistiven Effektes beruht wie beispielsweise dem AMR-Effekt (anisotroper magnetoresistiver Effekt) oder dem GMR-Effekt (von engl. giant magnetoresistance = Riesenmagnetowiderstand). Ein AMR-Sensorelement besteht beispielsweise aus vier schmalen Streifen aus einer dünnen ferromagnetischen Schicht, die in Form einer Wheatstone-Brücke geschaltet sind. Ein besonders gut geeignetes ferromagnetisches Material ist Mu-Metall (engl.: permalloy). Mu-Metall ist eine weichmagnetische Nickel-Eisen-Legierung hoher magnetischer Permeabilität.

Beim Magnetfeldsensor 4 der Fig. 5 ist das magnetische Element 10 ein AMR-Sensorelement, das als strukturierte Schicht auf den Halbleiterchip 9 aufgebracht wurde, wobei diese Schicht eine Wheatstone-Brücke bildet. Die vier Anschlüsse der Wheatstone-Brücke sind elektrisch mit der im Halbleiterchip 9 untergebrachten Betriebs- und Auswerteelektronik für das AMR-Sensorelement verbunden. Wesentlich ist, dass das AMR-Sensorelement mit den Endbereichen des Ringkonzentrators 2 wie oben beschrieben überlappt.

Anstelle eines AMR-Sensorelementes kann auch ein GMR-Sensorelement verwendet werden. Ein GMR-Sensorelement enthält nicht eine einzige ferromagnetische Schicht, sondern eine Schichtfolge aus sich abwechselnden ferromagnetischen und nichtmagnetischen dünnen Schichten mit einigen Nanometern Schichtdicke. Auch hier ist wesentlich, dass das GMR-Sensorelement mit den Endbereichen des Ringkonzentrators 2 überlappt.

Ein Fluxgate Sensor enthält einen ferromagnetischen Kern, der von einer Erregerspule und einer Auslesespule umwickelt ist. Wenn der Magnetfeldsensor 4 ein Fluxgate Sensor ist, dann bildet der ferromagnetische Kern das magnetische Element 10. Die Windungen der Erregerspule und der Auslesespule sind mit Vorteil in der Planartechnologie hergestellt, beispielsweise aus auf einer Leiterplatte aufgebrachten Leiterbahnen und Bonddrähten, wie dies für eine Spule 16 weiter unten beschrieben ist.

Die Abschirmung 5 ist ein Streifen aus ferromagnetischem Material, dessen Dicke wesentlich grösser, nämlich um mindestens einen Faktor 5, als die Dicke des Ringkonzentrators 2 ist. Im Beispiel beträgt die Dicke des Ringkonzentrators 2 etwa 0.1 mm, die Dicke der Abschirmung etwa 1 mm. Die Abschirmung 5 liegt in der gleichen Ebene wie der Ringkonzentrator 2 und umschliesst den Ringkonzentrator 2 auf etwa drei Seiten, d.h. die Abschirmung 5 ist ein typischerweise etwa ,,U" (Fig. 1) oder "C" (Fig. 2) - förmiger Streifen. Die Abschirmung 5 ist so orientiert, dass sich der Magnetfeldsensor 4 im Bereich der Öffnung des ,,U" bzw. ,,C" befindet. Die Abschirmung 5 hat eine Hauptaufgabe und eine fakultative Zusatzaufgabe. Die Hauptaufgabe besteht darin, den Magnetfeldsensor 4 im Messbereich kleiner Ströme gegen äussere Magnetfelder abzuschirmen, die in der Ebene des Ringkonzentrators 2 verlaufen. Dieser Messbereich ist der Bereich, in dem der Ringkonzentrator 2 magnetisch nicht in Sättigung ist. Dieser erste Messbereich erstreckt sich über einen Bereich von 0 A bis etwa 1₁ mit typischerweise I₁ ≅ 5 A oder I₁ ≅ 10 A. Wenn der Ringkonzentrator 2 magnetisch in Sättigung ist, verstärkt er das vom Strom I erzeugte Magnetfeld nicht mehr weiter, er ist magnetisch transparent. Die fakultative Zusatzaufgabe der Abschirmung 5 besteht nun darin, in einem zweiten Messbereich, der direkt an den ersten Messbereich anschliesst, als Magnetfeldkonzentrator zu wirken und das vom Strom I erzeugte Magnetfeld im Bereich des Magnetfeldsensors 4 zu verstärken, d.h. in diesem Messbereich wirkt die Abschirmung 5 zusammen mit den Magnetfeldkonzentratoren 12, 13 als verstärkender Magnetkreis. Dieser zweite Messbereich ist im Beispiel der Bereich von I₁ bis 100 A. Der Übergang vom ersten Messbereich zum zweiten Messbereich ist fliessend und nicht durch eine scharfe Grenze definiert.

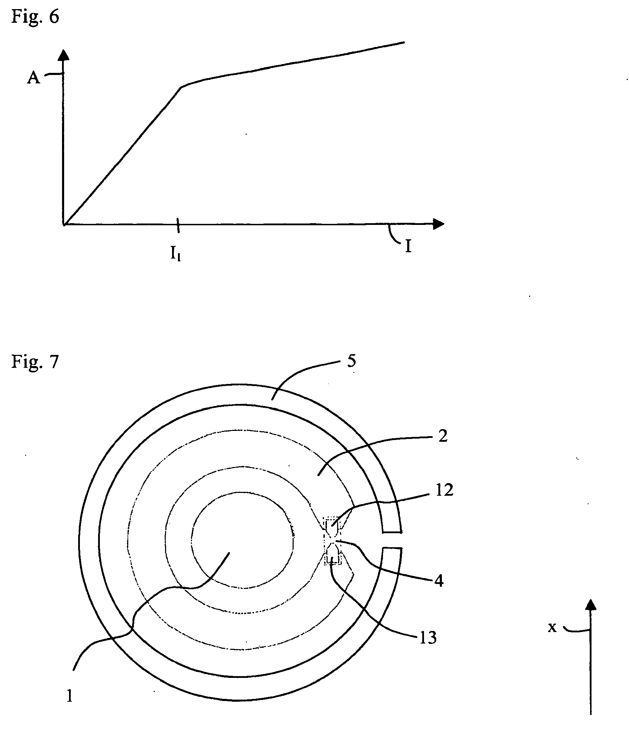

Die Fig. 6 zeigt die Kennlinie des Magnetfeldsensors 4 in Funktion des Stroms I.

Die Abschirmung 5 kann auch so ausgelegt sein, dass sie nur die Hauptaufgabe erfüllt, nämlich die Abschirmung des Magnetfeldsensors 4 gegen äussere Magnetfelder. In diesem Fall umschliesst die Abschirmung 5 mit Vorteil den Ringkonzentrator 2 beinahe vollständig, d.h. der Luftspalt 14 ist relativ schmal, z.B. nur 1 mm breit, wie dies in der Fig. 7 gezeigt ist.

Die Vorrichtung umfasst mit Vorteil weiter eine mit einem Strom beaufschlagbare Spule 16 (Fig. 1, 2) mit mehreren Windungen, die um den Ringkonzentrator 2 gewickelt sind. Die Windungen sind aus auf einer Leiterplatte aufgebrachten Leiterbahnen 17 (gestrichelte Linien) und aus Bonddrähten 18 (ausgezogene Linien) zusammengesetzt. Anstelle der Bonddrähte 18 kann auch eine zweite Leiterplatte eingesetzt werden, die den Bonddrähten entsprechende Leiterbahnen aufweist, die über so genannte ,,Bumps" mit den Leiterbahnen 17 verbunden sind.

Die Spule 16 kann verwendet werden, um im ersten Messbereich
a) den Magnetfeldsensor zu kalibrieren und im so genannten ,,open loop" Modus zu betreiben, und/oder
b) den Magnetfeldsensor im sogenannten ,,closed loop" Modus zu betreiben.

Im ,,open loop" Modus wird die Spule 16 für eine Eichung oder eine Nacheichung des Magnetfeldsensors 4 zu einem beliebigen Zeitpunkt mit einem vorbestimmten Kalibrierungsstrom beaufschlagt. Der Kalibrierungsstrom kann in Phasen, während denen bekannt ist, dass kein Strom durch den Stromleiter 1 fliesst, oder während einer Messung fliessen. Der Kalibrierungsstrom kann beispielsweise ein positiver Gleichstromimpuls und/oder ein negativer Gleichstromimpuls sein oder einen treppenförmigen Verlauf haben, so dass das Kalibrierungssignal des Magnetfeldsensors 4 von seinem allfälligen Messsignal unterscheidbar ist.

Im ,,closed loop" Modus wird die Spule 16 während des Messbetriebs mit einem Strom K(t) beaufschlagt, der im Luftspalt 14 ein Magnetfeld erzeugt, das dem Magnetfeld entgegengesetzt ist, das der zu messende Strom I(t) erzeugt, wobei der Parameter t die Zeit bezeichnet. In diesem Modus regelt die elektronische Schaltung den Strom K(t) so, dass das Ausgangssignal des Magnetfeldsensors 4 immer den Wert 0 hat. Das Messsignal ist in diesem Fall der Strom K(t).

Weil der effektive Luftspalt des durch den Ringkonzentrator 2 und das magnetische Element 10 des Magnetfeldsensors 4 gebildeten Magnetkreises wie oben beschrieben entweder sehr schmal oder in seiner Wirkung sogar vernachlässigbar ist, reichen wenige Windungen der Spule 16 und ein geringer Strom von wenigen mA aus, um im ,,open loop" Modus ein Magnetfeld zur Kalibrierung mit der erforderlichen Stärke zu erzeugen. Dasselbe gilt analog im ,,closed loop" Modus für den Strom K(t).

Die erfindungsgemässe Vorrichtung zur Strommessung kann mit einer für die Messung von noch grösseren Strömen ausgelegten Vorrichtung, beispielsweise mit einer in der EP 1811311 beschriebenen Vorrichtung, kombiniert werden, wobei der Stromleiter mit Vorteil eine beiden Vorrichtungen gemeinsame Stromschiene ist.

Die erfindungsgemässe Vorrichtung hat mehrere Vorteile:
- Der magnetische Widerstand des durch den Ringkonzentrator 2 und den Sensor 4 gebildeten Magnetkreises ist sehr gering, da er beim Einsatz eines Hallsensors als Magnetfeldsensor 4 nur einen Luftspalt von etwa 30 µm aufweist. Bei der Verwendung eines magnetoresistiven Sensors als Magnetfeldsensor 4 ist der magnetische Widerstand noch geringer, da der magnetoresistive Sensor selbst ferromagnetische Schichten umfasst, so dass der effektive Luftspalt des Magnetkreises noch kleiner wird oder verschwindet. Daraus resultiert eine hohe Empfindlichkeit der Vorrichtung.
- Der Strom, der im ,,closed loop" Modus durch die Spule 16 fliessen muss, um das von dem zu messenden Strom I erzeugte Magnetfeld zu kompensieren, ist viel kleiner als im Stand der Technik.
- Wenige Windungen der Spule 16 und ein relativ geringer, durch die Spule 16 fliessender Kalibrierungsstrom reichen aus, um den Magnetfeldsensor 4 im ,,open loop" Modus zu kalibrieren.
- Der Materialaufwand ist markant geringer als im Stand der Technik.
- Die Vorrichtung basiert auf Prozessen der Planartechnologie mit deren Vorteilen.

## Patentansprüche

1. Vorrichtung zur Messung eines durch einen Stromleiter (1) fliessenden Stroms, umfassend
einen Ringkonzentrator (2) aus ferromagnetischem Material mit einem Luftspalt (3), wobei sich der Ringkonzentrator (2) in einer im wesentlichen senkrecht zum Stromleiter (1) verlaufenden Ebene erstreckt und wobei eine senkrecht zur Ebene gemessene Dicke des Ringkonzentrators (2) um mindestens einen Faktor 10 geringer ist als eine in der Ebene gemessene Breite des Ringkonzentrators (2),
einen Magnetfeldsensor (4) mit einem Halbleiterchip (9) und einem auf dem Halbleiterchip (9) angebrachten magnetischen Element (10), wobei der Magnetfeldsensor (4) unterhalb oder oberhalb des Luftspalts des Ringkonzentrators (2) angeordnet ist und den Luftspalt (3) überbrückt, und wobei ein erster Endbereich des magnetischen Elementes (10) und ein erster Endbereich des Ringkonzentrators (2) und ein zweiter Endbereich des magnetischen Elementes (10) und ein zweiter Endbereich des Ringkonzentrators (2) überlappen, und
eine Abschirmung (5), die den Ringkonzentrator (2) in der durch den Ringkonzentrator (2) aufgespannten Ebene teilweise umschliesst.

2. Vorrichtung nach Anspruch 1, **dadurch gekennzeichnet, dass** die Abschirmung (5) den Ringkonzentrator (2) in der genannten Ebene mit Ausnahme eines schmalen Luftspalts vollständig umschliesst.

3. Vorrichtung nach Anspruch 1, **dadurch gekennzeichnet, dass** die Abschirmung (5) "U" -förmig oder "C" -förmig ist.

4. Vorrichtung nach einem der Ansprüche 1 bis 3, **dadurch gekennzeichnet, dass** der Ringkonzentrator (2) auf einem Träger (8) aufgebracht ist, dass der Magnetfeldsensor (4) in einem Gehäuse verpackt ist und dass Enden (6, 7) des Ringkonzentrators (2) auf dem Gehäuse aufliegen.

5. Vorrichtung nach einem der Ansprüche 1 bis 4, **dadurch gekennzeichnet, dass** das magnetische Element ein magnetoresistiver Sensor ist.

6. Vorrichtung nach einem der Ansprüche 1 bis 4, **dadurch gekennzeichnet, dass** das magnetische Element der ferromagnetische Kern eines Fluxgate Sensors ist.

7. Vorrichtung nach einem der Ansprüche 1 bis 4, **dadurch gekennzeichnet, dass** das magnetische Element (10) gebildet ist durch zwei Magnetfeldkonzentratoren (12, 13), die durch einen Luftspalt (14) getrennt sind, und dass im Bereich dieses Luftspalts (14) mindestens ein Hallelement (11; 15A, 15B) angeordnet ist.

8. Vorrichtung nach einem der Ansprüche 1 bis 7, **dadurch gekennzeichnet, dass** weiter eine mit einem Strom beaufschlagbare Spule (16) mit mehreren in Planartechnologie gefertigten Windungen, die um den Ringkonzentrator (2) gewickelt sind, vorhanden ist, und dass der Halbleiterchip (9) eine elektronische Schaltung für den Betrieb der Spule (16) im "open loop" Modus und/oder im "closed loop" Modus enthält.

## Claims

1. Device for measuring a current flowing through a current conductor (1), comprising
a ring concentrator (2) made of a ferromagnetic material with an air gap (3), wherein the ring concentrator (2) extends in a plane extending substantially perpendicularly to the current conductor (1), and wherein a thickness of the ring concentrator (2) measured perpendicularly to the plane is lower by a factor of at least 10 than a width of the ring concentrator (2) measured in the plane;
a magnetic field sensor (4) with a semiconductor chip (9) and a magnetic element (10) attached to the semiconductor chip (9), wherein the magnetic field sensor (4) is arranged beneath or above the air gap of the ring concentrator (2) and bridges the air gap (3), and wherein a first end region of the magnetic element (10) and a first end region of the ring concentrator (2) and a second end region of the magnetic element (10) and a second end region of the ring concentrator (2) overlap, and
a shielding (5) which partly surrounds the ring concentrator (2) in the plane spanned through the ring concentrator (2).

2. Device according to claim 1, **characterized in that** the shielding (5) surrounds the ring concentrator (2) completely in said plane, with the exception of a narrow air gap.

3. Device according to claim 1, **characterized in that** the shielding (5) is U-shaped or C-shaped.

4. Device according to any of claims 1 to 3, **characterized in that** the ring concentrator (2) is attached to a support (8), that the magnetic field sensor (4) is encased in a housing and ends (6, 7) of the ring concentrator (2) rest on the housing.

5. Device according to any of claims 1 to 4, **characterized in that** the magnetic element is a magnetoresistive sensor.

6. Device according to any of claims 1 to 4, **characterized in that** the magnetic element is the ferromagnetic core of a fluxgate sensor.

7. Device according to any of claims 1 to 4, **characterized in that** the magnetic element (10) is formed by two magnetic field concentrators (12, 13) which are separated by an air gap (14), and that at least one Hall element (11; 15A, 15B) is arranged in the region of said air gap (14).

8. Device according to any of claims 1 to 7, **characterized in that** further a coil (16) is present, which can be supplied with current and comprises several windings which are produced in planar technology and which are wound around the ring concentrator (2), and that the semiconductor chip (9) contains an electronic circuit for the operation of the coil (16) in open-loop and/or closed-loop mode.

## Revendications

1. Dispositif pour la mesure d'un courant passant dans un conducteur électrique (1), comprenant
un concentrateur annulaire (2) en matériau ferromagnétique avec un entrefer (3), le concentrateur annulaire (2) s'étendant dans un plan sensiblement perpendiculaire au conducteur électrique (1) et une épaisseur du concentrateur annulaire (2) mesurée perpendiculairement au plan étant plus petite d'au moins un facteur 10 qu'une largeur du concentrateur annulaire (2) mesurée dans le plan,
un capteur de champ magnétique (4) avec une puce de semi-conducteurs (9) et un élément magnétique (10) appliqué sur la puce de semi-conducteurs (9), le capteur de champ magnétique (4) étant disposé en dessous ou au-dessus de l'entrefer du concentrateur annulaire (2) et franchissant l'entrefer (3), et une première région terminale de l'élément magnétique (10) et une première région terminale du concentrateur annulaire (2) et une deuxième région terminale de l'élément magnétique (10) et une deuxième région terminale du concentrateur annulaire (2) se chevauchant, et
un blindage (5) qui entoure partiellement le concentrateur annulaire (2) dans le plan étendu par le concentrateur annulaire (2).

2. Dispositif selon la revendication 1, **caractérisé en ce que** le blindage (5) entoure complètement le concentrateur annulaire (2) dans ledit plan, à l'exception d'un étroit entrefer.

3. Dispositif selon la revendication 1, **caractérisé en ce que** le blindage (5) est en forme de « U » ou en forme de « C ».

4. Dispositif selon l'une des revendications 1 à 3, **caractérisé en ce que** le concentrateur annulaire (2) est disposé sur un support (8), **en ce que** le capteur de champ magnétique (4) est emballé dans un boîtier et **en ce que** des extrémités (6, 7) du concentrateur annulaire (2) reposent sur le boîtier.

5. Dispositif selon l'une des revendications 1 à 4, **caractérisé en ce que** l'élément magnétique est un capteur magnétorésistif.

6. Dispositif selon l'une des revendications 1 à 4, **caractérisé en ce que** l'élément magnétique est le noyau ferromagnétique d'un capteur de type « fluxgate ».

7. Dispositif selon l'une des revendications 1 à 4, **caractérisé en ce que** l'élément magnétique (10) est formé par deux concentrateurs de champ magnétique (12, 13) qui sont séparés par un entrefer (14), et **en ce qu'**au moins un élément à effet Hall (11 ; 15A, 15B) est disposé dans la région de cet entrefer (14).

8. Dispositif selon l'une des revendications 1 à 7, **caractérisé en ce qu'**il est prévu en outre une bobine (16) pouvant être exposée à un courant, avec plusieurs enroulements de technologie planaire qui sont enroulés autour du concentrateur annulaire (2), et **en ce que** la puce de semi-conducteurs (9) contient un circuit électronique pour faire fonctionner la bobine (16) en mode « boucle ouverte » (open loop) et/ou en mode « boucle fermée » (closed loop).
